# EUROPEAN PATENT SPECIFICATION

(11) **EP 4 354 693 B1**
(45) Date of publication and mention of the grant of the patent: **19.08.2026**
(21) Application number: 22940407.4
(22) Date of filing: 27.12.2022
(51) Int. Cl.: H02J 7/00, G01R 31/3842, H01M 10/48, B60L 58/22, H01M 10/42

(54) **CELL BALANCING METHOD AND BATTERY PACK EMPLOYING SAME**
ZELLENAUSGLEICHSVERFAHREN UND BATTERIEPACK DAMIT
PROCÉDÉ D'ÉQUILIBRAGE DE CELLULES ET BLOC-BATTERIE L'UTILISANT

(30) Priority: 27.04.2022 KR 20220052179
(43) Date of publication of application: 17.04.2024
(73) Proprietor: LG Energy Solution, Ltd., Seoul 07335 (KR)
(72) Inventor: JEONG, Tae Cheol, Daejeon 34122 (KR); YOON, Seog Jin, Daejeon 34122 (KR)
(74) Representative: Goddar, Heinz J.
(86) International application number: PCT/KR2022/021389
(87) International publication number: WO 2023/210913

(56) References cited:
- EP-A1- 3 678 276
- JP-A- 2018 023 257
- JP-A- 2020 046 335
- KR-A- 20190 105 847
- KR-A- 20220 051 597
- US-A1- 2018 041 052
- US-A1- 2019 052 098
- US-A1- 2021 305 817

## Description

### TECHNICAL FIELD

The present invention relates to a battery pack with a cell balancing method applied thereto, particularly a cell balancing method capable of increasing cell balancing efficiency by controlling a cell balancing switching pulse width modulation (PWM) duty ratio.

### BACKGROUND ART

A battery pack mounted in a device requiring a chargeable electricity storage device, such as a portable electronic device, an electric vehicle, or an energy storage device, includes a plurality of battery cells connected in series or parallel.

Each battery cell included in the battery pack has a different capacity due to various reasons in the manufacturing process. Accordingly, in the battery pack, a voltage difference between the battery cells occurs during a charge/discharge cycle, and as the number of charge/discharge cycles increases, the voltage difference between the battery cells is also accumulated and increased. As the above situation is repeated, the lifespan of the battery pack is reduced. In order to solve the aforementioned problem, a cell balancing technology is applied to the battery pack to adjust the voltage difference between battery cells generated during charging/discharging.

The cell balancing technology is largely divided into active cell balancing and passive cell balancing, and in general, the passive balancing method is mainly used because of circuit configuration and low cost. The passive balancing method is a method in which, when the voltage of a specific battery cell or module is higher than a reference voltage (minimum battery cell or module voltage), the voltage is lowered to the level of the reference voltage by performing forced discharge through a cell balancing resistor. More specifically, a method of discharging a connection circuit between a discharge resistor and a battery cell through PWM switching control using a field-effect transistor (FET) is used. Here, the PWM switching is controlled with a predetermined PWM duty ratio considering input values such as battery management system (BMS) temperature and cell voltage/current. In this case, when the voltage difference between battery cells or modules is large, it may take a long time to complete cell balancing, and thus, for example, when it is necessary to stabilize the voltage difference between battery cells or modules in a short time, it may be difficult to respond quickly, and good balancing efficiency is also difficult to expect.

Examples of the related art include following documents.
KR 1459539 B1
US 2018/0041052 A1 relates to a power storage apparatus.
US 2019/0052098 A1 elates to battery cell balancing using duty ratio control, and more particularly, to a battery cell balancing method and system including detecting a temperature of a resistance caused by a current flowing in a battery cell during battery cell balancing, calculating a duty ratio of the battery cell balancing according thereto, and detecting a voltage of the battery cell when a predetermined time elapses after the cell balancing operation.
US 2021/305817 A1 relates to a cell-balancing method and a battery management system for performing the same.

### DISCLOSURE OF THE INVENTION

### TECHNICAL PROBLEM

The present invention has been made to solve the above problems, and is to provide a battery pack to which cell balancing method capable of increasing cell balancing efficiency by variably controlling cell balancing switching PWM duty ratio depending on a cell balancing current, a BMS temperature, and an operating mode is applied.

### TECHNICAL SOLUTION

According to an embodiment of the present disclosure, there is provided a method for cell balancing between at least two or more battery banks included in a battery pack, the method including: a battery information acquisition step of acquiring battery information including current, voltage, and temperature of a battery at regular intervals; a cell balancing necessity determination step of determining whether the cell balancing is necessary by using the battery information acquired in the battery information acquisition step; a cell balancing start step of turning on a cell balancing switch with an initial duty ratio and executing an initial cell balancing mode when the determination is made that the cell balancing is necessary in the cell balancing necessity determination step; a cell balancing switch duty ratio change determination step of determining whether a duty ratio of the cell balancing switch needs to be changed by using the acquired battery information after the cell balancing starts; a cell balancing switch duty ratio increase step of increasing the duty ratio of the cell balancing switch by a predetermined range when the determination is made that the duty ratio of the cell balancing switch needs to be changed in the cell balancing switch duty ratio change determination step; a cell balancing continuation determination step of determining whether to continue the cell balancing using the acquired battery information; a diagnosis count increase determination step of increasing the number of diagnosis counting when the determination is made that the cell balancing is to be continued in the cell balancing continuation determination step and the number of cell balancing cycles exceeds a predetermined reference number of cell balancing cycles; and a cell balancing mode change step of changing a cell balancing mode and returning to the cell balancing switch duty ratio change determination step when the number of diagnosis counting counted through the diagnosis count increase determination step is less than or equal to a predetermined reference number of diagnosis counting.

Further, the method may further include: a cell balancing end step of controlling the cell balancing switch to be turned off when the determination is made that the cell balancing is not to be continued in the cell balancing continuation determination step; and a diagnosis end step of reporting a diagnosis result and ending a procedure when the counted number of diagnosis counting exceeds the predetermined reference number of diagnosis counting through the diagnosis count increase determination step.

Meanwhile, the cell balancing necessity determination step may include determining that the cell balancing is necessary, when a bank voltage maximum difference value that is a difference between a maximum voltage and a minimum voltage among voltage values of the battery banks included in the acquired battery information exceeds a predetermined reference voltage difference value and a state of charge (SOC) is within a predetermined reference range.

Meanwhile, the cell balancing switch duty ratio change determination step may include: determining that the duty ratio of the cell balancing switch needs to be changed when a BMS temperature included in the acquired battery information is less than a predetermined reference temperature and a cell balancing current is less than a reference current; and determining that the duty ratio of the cell balancing switch does not need to be changed when any one of the BMS temperature and the cell balancing current does not satisfy a condition.

Meanwhile, the cell balancing continuation determination step may include: determining that cell balancing does not need to be continued, when a maximum bank voltage difference value that is a difference between a maximum voltage and a minimum voltage among voltage values of the battery banks included in the acquired battery information is less than or equal to a predetermined reference voltage difference; and determining that cell balancing needs to be continued when the bank voltage difference value exceeds a predetermined reference voltage difference value.

Here, the cell balancing mode may be one of a charging mode, a standby mode, and a discharging mode, and the cell balancing mode change step may include changing the cell balancing mode in an order of the charging mode, the standby mode, and the discharging mode.

According the present invention, there is provided a battery pack including: at least two or more battery banks including a plurality of battery cells; a battery information measurement unit that measures battery information including current, voltage, temperature, and an SOC of a battery at regular intervals; a cell balancing necessity determination unit that determines whether cell balancing is necessary by using the battery information acquired from the battery information measurement unit; a duty ratio change determination unit that determines whether a duty ratio of a cell balancing switch needs to be changed by using the battery information acquired from the battery information measurement unit, after a cell balancing operation is activated by a result of the determination of the cell balancing necessity determination unit; a count unit that counts the number of cell balancing cycles and the number of diagnosis counting; a diagnosis count increase determination unit that determines whether to increase the number of diagnosis counting depending on whether the cell balancing needs to be continued and whether the number of cell balancing cycles exceeds a predetermined reference number of cell balancing cycles; and a cell balancing mode change determination unit that determines whether to change the cell balancing mode depending on whether the number of diagnosis counting counted by the count unit is less than or equal to a predetermined reference number of diagnosis counting.

Further, the battery pack may further include: a cell balancing control unit that activate a cell balancing operation with an initial cell balancing switch and in an initial cell balancing mode when the cell balancing necessity determination unit determines that the cell balancing is necessary, and then makes setting by changing each of the duty ratio of the cell balancing switch and the cell balancing mode depending on whether a predetermined condition is satisfied with a change in a battery state; and a cell balancing unit that includes a cell balancing resistor connected to a positive electrode of each battery bank to consume voltage of the battery bank and a cell balancing switch for turning on and off a connection path between the cell balancing resistor and the battery bank.

Meanwhile, the cell balancing necessity determination unit may include: a voltage difference calculation unit that calculates a bank voltage difference that is a difference between a maximum voltage and a minimum voltage among voltage values of battery banks included in the battery information acquired from the battery information measurement unit; a voltage comparison unit that compares a bank voltage difference value calculated by the voltage difference calculation unit with a predetermined reference voltage difference value to determine whether the bank voltage difference value exceeds the predetermined reference voltage difference value, and outputs a signal corresponding to a result of the comparison; an SOC comparison unit that compares an SOC included in the battery information acquired from the battery information measurement unit with values of a predetermined reference SOC range to determine whether the SOC is within the predetermined reference SOC range, and outputs an SOC satisfaction signal when the SOC is within the predetermined reference SOC range; and a necessity determination unit that determines that the cell balancing is necessary when the calculated bank voltage difference value exceeds the predetermined reference voltage difference value and the SOC is within the predetermined reference SOC range.

More specifically, the voltage comparison unit may output a voltage-excess signal when the calculated bank voltage difference value exceeds the predetermined reference voltage difference value as the result of the comparison, and output a voltage-or-less signal when the calculated bank voltage difference value is less than or equal to the predetermined reference voltage difference value, and the necessity determination unit may determine that the cell balancing is necessary and outputs a balancing start signal, when both the voltage-excess signal and the SOC satisfaction signal are output.

Meanwhile, the necessity determination unit may determine that the cell balancing is not to be continued and output a balancing end signal, when the voltage-or-less signal is output from the voltage comparison unit after the balancing start signal is output; and determine that the cell balancing is to be continued and output a balancing continuation signal, when the voltage-excess signal is output from the voltage comparison unit after the balancing start signal is output.

Meanwhile, the duty ratio change determination unit may include: a temperature comparison unit that, after the balancing start signal is output from the necessity determination unit, compares a BMS temperature included the battery information acquired from the battery information measurement unit with a predetermined reference temperature to determine whether the BMS temperature is less than the predetermined reference temperature, and outputs a temperature satisfaction signal when the BMS temperature is less than the predetermined reference temperature; a current comparison unit that, after the balancing start signal is output from the necessity determination unit, compares a cell balancing current included the battery information acquired from the battery information measurement unit with a predetermined reference current to determine whether the cell balancing current is less than the predetermined reference current, and outputs a current satisfaction signal when the cell balancing current is less than the predetermined reference current; and a change determination unit that determines whether the duty ratio of the cell balancing switch of the cell balancing unit needs to be changed according to a result of comparisons of the temperature comparison unit and the current comparison unit.

More specifically, the change determination unit may determine that the duty ratio of the cell balancing switch needs to be changed and outputs a duty ratio change signal, when both the temperature satisfaction signal and the current satisfaction signal are output from the temperature comparison unit and the current comparison unit, and determine that the duty ratio of the cell balancing switch does not need to be changed when any one of the temperature satisfaction signal and the current satisfaction signal is not output from the temperature comparison unit and the current comparison unit.

Meanwhile, the count unit may include a cycle number count unit that, when the balancing start signal is output from the necessity determination unit of the cell balancing necessity determination unit, counts the number of cell balancing cycles from a point in time when the balancing start signal is output.

Meanwhile, the diagnosis count increase determination unit may include: a number comparison unit that compares the number of cell balancing cycles counted by the cycle number count unit of the count unit with the predetermined reference number of cell balancing cycles to determine whether the number of cell balancing cycles exceeds the predetermined reference number of cell balancing cycles, and outputs a cycle-number-excess signal when the number of cell balancing cycles exceeds the predetermined reference number of cell balancing cycles; and an increase determination unit that determines that the number of diagnosis counting is to be increased and outputs a diagnosis-counting-increase signal, when the balancing continuation signal is output from the necessity determination unit of the cell balancing necessity determination unit and the cycle-number-excess signal is output from the number comparison unit.

Meanwhile, the count unit may further include a number-of-diagnosis-counting count unit that increases the number of diagnosis counting when a diagnosis counting signal is output from the increase determination unit of the diagnosis count increase determination unit.

Meanwhile, the cell balancing mode change determination unit may determine that the cell balancing mode needs to be changed and outputs a mode change signal, when the number of diagnosis counting counted by the number-of-diagnosis-counting count unit is less than or equal to the reference number of diagnosis counting.

Meanwhile, the cell balancing control unit may include: a switch control unit that turns on the cell balancing switch of the cell balancing unit with the initial duty ratio when the balancing start signal is output from the necessity determination unit of the cell balancing necessity determination unit; and a cell balancing mode setting unit that sets the cell balancing mode to the initial cell balancing mode when the balancing start signal is output from the necessity determination unit of the cell balancing necessity determination unit.

Meanwhile, the switch control unit of the cell balancing control unit may turn on the cell balancing switch with the duty ratio of the cell balancing switch set to be increased by a predetermined range when the duty ratio change signal is output from the change determination unit of the duty ratio change determination unit, and turn off the cell balancing switch when the balancing end signal is output from the necessity determination unit of the cell balancing necessity determination unit.

Meanwhile, the cell balancing mode setting unit of the cell balancing control unit may make setting by changing the cell balancing mode when the mode change signal is output from the cell balancing mode change determination unit.

Here, the cell balancing mode may be one of a charging mode, a standby mode, and a discharging mode, and changing of the cell balancing mode may be set in an order of the charging mode, the standby mode, and the discharging mode.

### ADVANTAGEOUS EFFECTS

According to the embodiments of the present disclosure, cell balancing is performed by variably controlling a cell balancing switch PWM duty ratio depending on a cell balancing current, a BMS temperature, and an operating mode.

Therefore, even when the voltage difference between battery cells or modules is large, it is possible to stabilize the voltage difference in a short time, and to increase the cell balancing efficiency.

### BRIEF DESCRIPTION OF THE DRAWINGS

FIG. 1 is a flowchart illustrating a cell balancing for the battery pack method according to an embodiment of the present invention.
FIG. 2 is a diagram schematically illustrating an overall configuration of a battery pack according to an embodiment of the present invention.

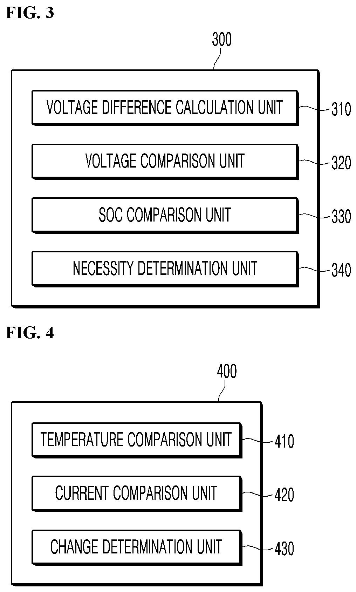

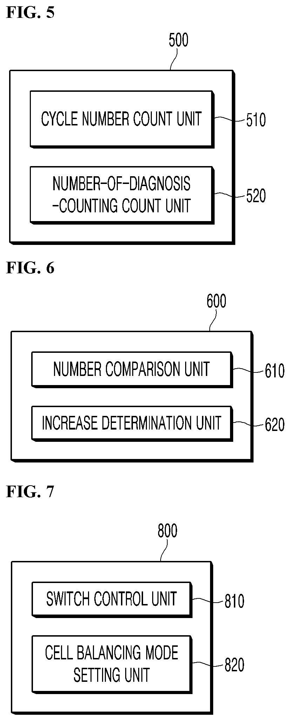

FIGS. 3 to 7 are diagrams illustrating detailed configurations of each component.

### MODE FOR CARRYING OUT THE INVENTION

Hereinafter, exemplary embodiments of the present disclosure will be described in detail with reference to the accompanying drawings so that those skilled in the art may easily perform the present disclosure. However, the present disclosure may be implemented by various modifications and is not limited to the exemplary embodiments described herein. In the drawings, in order to clarify the present disclosure, parts that are not related to description are omitted and like reference numerals represent like elements throughout the specification.

Hereinafter, exemplary embodiments will be described in detail with reference to the drawings.

### 1. Cell balancing method for the battery pack according to the present invention

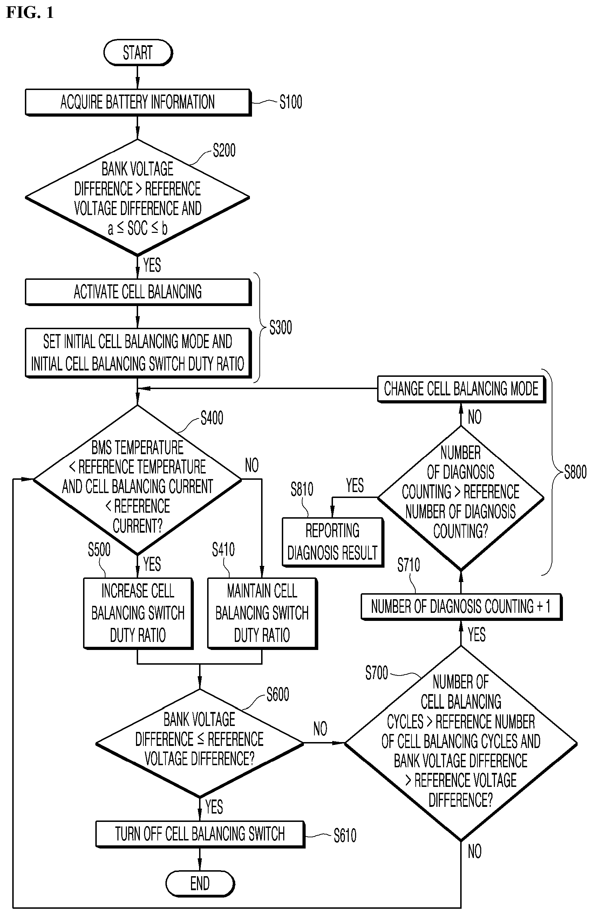

FIG. 1 is a flowchart illustrating a cell balancing method according to an embodiment of the present invention.

Referring to FIG. 1, the cell balancing method for the battery pack according to the present invention may include the following steps.

### 1.1. Battery information acquisition step (S100)

A battery information acquisition step S100 is a step of acquiring battery information including current, voltage, temperature, state of charge (SOC), and the like, of a battery at regular intervals.

Here, the voltage of the battery may be a voltage value of each battery bank 100 composed of a plurality of battery cells (not shown).

In addition, the temperature of the battery may be a BMS temperature value obtained by measuring the temperature of a resistor, an FET, and the like, connected to a battery monitoring integrated circuit (BMIC).

### 1.2. Cell balancing necessity determination step (S200)

A cell balancing necessity determination step S200 is a step of determining whether cell balancing is necessary by using the battery information acquired in the battery information acquisition step S100.

More specifically, when a bank voltage difference value, which is the difference between a maximum voltage value and a minimum voltage value among voltage values of the battery banks included in the acquired battery information, exceeds a reference voltage difference and the SOC is within a predetermined reference range, the determination is made that cell balancing is necessary.

### 1.3. Cell balancing start step (S300)

A cell balancing start step S300 is a step of activating cell balancing by setting a cell balancing switch (not shown) to an initial duty ratio and turning on the cell balancing switch, and executing an initial cell balancing mode, when the determination is made that cell balancing is necessary in the cell balancing necessity determination step S200.

Here, the initial duty ratio may be set to 20%, for example.

The cell balancing mode may be set to a charging mode, a standby mode, and a discharging mode.

In this case, when cell balancing is started, the cell balancing time may be counted from that point in time.

### 1.4. Cell balancing switch duty ratio change determination step (S400)

A cell balancing switch duty ratio change determination step S400 is a step of determining whether a duty ratio of the cell balancing switch needs to be changed by using the BMS temperature and the cell balancing current included in the battery information acquired through the battery information acquisition step S100.

Specifically, when both conditions that the BMS temperature is less than a reference temperature and the cell balancing current is less than the reference cell balancing current through comparison of the cell balancing current with the reference cell balancing current are satisfied, the determination may be made that the duty ratio of the cell balancing switch needs to be changed.

On the other hand, when the BMS temperature is not less than the reference temperature or the cell balancing current is not less than the reference cell balancing current, that is, when any one of the BMS temperature and the cell balancing current does not satisfy the conditions, the determination may be made that the duty ratio of the cell balancing switch does not need to be changed. In this case, the initial duty ratio and the initial cell balancing mode set in the cell balancing start step S300 are maintained (S410).

### 1.5. Cell balancing switch duty ratio increase step (S500)

A cell balancing switch duty ratio increase step S500 is a step of operating when the determination is made that the duty ratio of the cell balancing switch needs to be changed in the cell balancing switch duty ratio change determination step S400.

When the determination is made that the duty ratio of the cell balancing switch needs to be changed, the duty ratio of the cell balancing switch is increased by a predetermined range increment.

For example, assuming that the duty ratio of the initial cell balancing switch in the cell balancing start step S300 is "A" and the predetermined range increment is "a", the duty ratio of the cell balancing switch is increased to "A + a".

In this way, when the BMS temperature and cell balancing current do not satisfy certain conditions even though the cell balancing operation is executed with the initial duty ratio of the cell balancing switch and cell balancing mode, it is possible to increase cell balancing efficiency by stepwise increasing the duty ratio of the cell balancing switch.

Meanwhile, the increment "a" of the duty ratio of the cell balancing switch may be allowed the cell balancing operating range to be set to be larger in the order of the charging mode, the standby mode, and the discharging mode, thereby increasing the duty ratio of the switch with the cell balancing mode.

### 1.6. Cell balancing continuation determination step (S600)

A cell balancing continuation determination step S600 is a step of determining whether to continue cell balancing current in operation by using the battery information acquired through the battery information acquisition step S100.

More specifically, when a bank voltage difference value, which is the difference between a maximum voltage value and a minimum voltage value among voltage values of the battery banks included in the acquired battery information, exceeds a reference voltage difference, the determination is made that cell balancing in operation needs to be continued.

On the other hand, when the bank voltage difference value is less than or equal to the reference voltage difference, the determination is made that cell balancing in operation does not need to be continued, and a cell balancing end step (S610) of turning off the cell balancing switch is performed.

### 1.7. Diagnosis count increase determination step (S700)

A diagnosis count increase determination step S700 is a step of determining whether to increase the number of diagnosis counting according to a result of the determination of whether to continue cell balancing in the cell balancing continuation determination step S600 and a result of comparing the number of cell balancing cycles with the reference number of cell balancing cycles.

Specifically, when the determination is made that the cell balancing needs to be continued and the number of cell balancing cycles is less than or equal to a predetermined reference number of cell balancing cycles, the determination is made that an increase in the diagnosis count is not necessary and return to the cell balancing switch duty ratio change determination step S400 is performed. On the other hand, at this time, when the determination is made that cell balancing does not need to be continued although cell balancing is continued for the predetermined number of cell balancing cycles or for the cell balancing time, that is, when the bank voltage difference value does not exceed the reference voltage difference and falls within the predetermined reference range, the cell balancing mode may be changed in a method different from a cell balancing mode change step S800, which will be described below, before returning to cell balancing switch duty ratio change determination step S400. At this time, the cell balancing mode may be changed in the order of the discharging mode, the standby mode, and the charging mode, so that the increment of the duty ratio of the cell balancing switch may be reduced. In this case, when the mode before the change is the charging mode, the charging mode is maintained.

On the other hand, when the determination is made that the cell balancing needs to be continued and the number of cell balancing cycles exceeds the predetermined reference number of cell balancing cycles, a determination is made that the diagnosis count is to be increased and the number of diagnosis counting is increased (S710). That is, when the bank voltage difference value, which is the difference between the maximum voltage value and the minimum voltage value among the voltage values of the battery banks, exceeds the reference voltage difference in spite of performing cell balancing by a predetermined reference number of cell balancing or for a predetermined reference cell balancing time, the number of diagnosis counting is increased.

Meanwhile, in determining whether to increase the diagnosis count, it has been described that the number of cell balancing cycles is used in one embodiment, but the cell balancing operating time may be used in another embodiment. In this case, for example, a result of the determination of whether the cell balancing operating time is less than or equal to or exceeds a predetermined reference cell balancing operating time may be reflected in determining whether to increase the diagnosis count.

### 1.8. Cell balancing mode change step (S800)

In a cell balancing mode change step S800, the cell balancing mode may be changed in the cell balancing start step S300 depending on whether the number of diagnosis counting counted through the diagnosis count increase determination step S700 is less than or equal to a predetermined reference number of diagnosis counting.

Specifically, when the number of diagnosis counting is less than or equal to the predetermined reference number of diagnosis counting, the cell balancing mode is changed, and return to the cell balancing switch duty ratio change determination step S400 is performed.

Here, the cell balancing mode may be one of the charging mode, the standby mode, and the discharging mode, and the cell balancing mode may be changed in the order of the charging mode, the standby mode, and the discharging mode. For example, when the initial cell balancing mode is the charging mode, the cell balancing mode may be changed to the standby mode in the cell balancing mode change step S800. When the cell balancing mode is the discharge mode before the change, the discharge mode is maintained.

Depending on the condition of the case in which the bank voltage difference is not decreased even though cell balancing is performed for the predetermined number of cell balancing or cell balancing time in the diagnosis count increase determination step S700, the cell balancing mode is changed in the order of the charging mode, the standby mode and the discharging mode and cell balancing is continued, thereby making it possible to obtain a larger increment of the increment of the duty ratio of the cell balancing switch.

However, when the number of diagnosis counting exceeds the predetermined reference number of diagnosis counting, cell balancing is not performed any more, a diagnosis result is reported, and a diagnosis end step S810 of ending the procedure is performed.

### 2. Battery pack according to the present invention

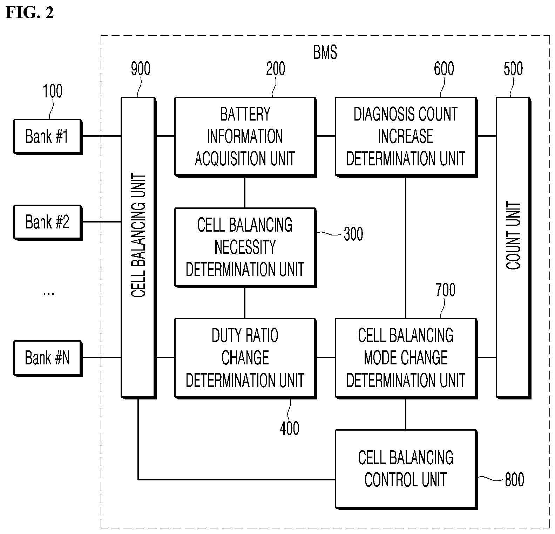

FIG. 2 is a diagram schematically illustrating an overall configuration of a battery pack according to an embodiment of the present invention.

Referring to FIG. 2, the battery pack of the present invention includes the following components.

### 2.1. Battery bank (100)

As shown in FIG. 2, the battery pack of the present invention includes at least two or more battery banks 100 including a plurality of battery cells (not shown).

### 2.2. Battery information measurement unit (200)

A battery information measurement unit 200 is a component that measures battery information including current, voltage, temperature, an SOC, and the like, of a battery at regular intervals.

Here, the voltage may be a voltage value for each battery bank. The voltage of the battery bank may be obtained, for example, by a method of measuring the voltage of each battery cell and measuring/calculating based on the voltage values of the measured battery cells.

Meanwhile, the temperature may be a BMS temperature value. The BMS temperature may be obtained by measuring the temperature of a resistor or FET connected to BMIC (Battery Monitoring Integrated Circuit), for example.

Meanwhile, the current may be a cell balancing current value.

As a method of measuring battery information including current, voltage, temperature, and SOC of the battery, a known method may be used.

### 2.3. Cell balancing necessity determination unit (300)

A cell balancing necessity determination unit 300 is a component that determines whether cell balancing of the battery is necessary by using the battery information acquired from the battery information measurement unit 200. The cell balancing necessity determination unit 300 may include the following sub-components.

### 2.3.1. Voltage difference calculation unit (310)

A voltage difference calculation unit 310 is a component that calculates a bank voltage difference value, which is a difference between a maximum voltage value and a minimum voltage value among voltage values of battery banks included in the battery information acquired from the battery information measurement unit 200.

### 2.3.2. Voltage comparison unit (320)

A voltage comparison unit 320 is a component that compares a bank voltage difference value calculated by the voltage difference calculation unit 310 with a predetermined reference voltage difference value to determine whether the bank voltage difference value exceeds the predetermined reference voltage difference value, and outputs a signal corresponding to a result of the comparison.

More specifically, when the calculated bank voltage difference value exceeds the predetermined reference voltage difference value as the result of the comparison, the voltage comparison unit 320 may output a voltage-excess signal indicating it.

On the other hand, when the calculated bank voltage difference value is less than or equal to the predetermined reference voltage difference value as the result of the comparison, the voltage comparison unit 320 may output a voltage-or-less signal indicating it.

### 2.3.3. SOC comparison unit (330)

An SOC comparison unit 330 may compare an SOC included in the battery information acquired from the battery information measurement unit 200 with values of a predetermined reference SOC range to determine whether the SOC is within the predetermined reference SOC range, and when the SOC is within the predetermined reference SOC range, may output, for example, an SOC satisfaction signal indicating it.

### 2.3.4. Necessity determination unit (340)

A necessity determination unit 340 is a component that determines whether cell balancing is necessary according to a result of the comparisons of the voltage comparison unit 320 and the SOC comparison unit 330.

More specifically, the necessity determination unit 340 determines that the cell balancing is necessary when the calculated bank voltage difference value exceeds the predetermined reference voltage difference value and the SOC is within the predetermined reference SOC range.

That is, when the voltage-excess signal is output from the voltage comparison unit 320 and the SOC satisfaction signal is all output from the SOC comparison unit 330, the necessity determination unit 340 may determine that the cell balancing is necessary, and may, for example, output a balancing start signal indicating it.

On the other hand, the necessity determination unit 340 determines that cell balancing does not need to be continued when the voltage-or-less signal is output from the voltage comparison unit 320 after the cell balancing starts (after the balancing start signal is output), and may, for example, output a balancing end signal indicating it.

On the other hand, when the voltage-excess signal is output from the voltage comparison unit 320 after the cell balancing starts (after the balancing start signal is output), the necessity determination unit 340 determines that cell balancing needs to be continued, and, may, for example, output a balancing continuation signal indicating it.

### 2.4. Duty ratio change determination unit (400)

A duty ratio change determination unit 400 is a component that determines whether a duty ratio of the cell balancing switch (not shown) of a cell balancing unit 900 needs to be changed by using the battery information acquired from the battery information measurement unit 200, after a cell balancing operation is activated by a result of the determination of the cell balancing necessity determination unit 300.

The duty ratio change determination unit 400 may include the following sub-components.

### 2.4.1. Temperature comparison unit (410)

A temperature comparison unit 410 may compare the BMS temperature included in the battery information acquired from the battery information measurement unit 200 with a predetermined reference temperature to determine whether the BMS temperature is less than the predetermined reference temperature, after cell balancing is activated (after the balancing start signal is output), and when the BMS temperature is less than the predetermined reference temperature, may, for example, output a temperature satisfaction signal indicating it.

### 2.4.2. Current comparison unit (420)

A current comparison unit 420 may compare the cell balancing current included in the battery information acquired from the battery information measurement unit 200 with a predetermined reference current to determine whether the cell balancing current is less than the predetermined reference current, after cell balancing is activated (after the balancing start signal is output), and when the cell balancing current is less than the predetermined reference current, may, for example, output a current satisfaction signal indicating it.

### 2.4.3. Change determination unit (430)

A change determination unit 430 is a component that determines whether the duty ratio of the cell balancing switch (not shown) needs to be changed according to a result of comparisons of the temperature comparison unit 410 and the current comparison unit 420.

More specifically, when the BMS temperature is less than the predetermined reference temperature and the cell balancing current is less than the predetermined reference current, that is, when both the temperature satisfaction signal and the current satisfaction signal are output from the temperature comparison unit 410 and the current comparison unit 420, the change determination unit 430 determines that the duty ratio of the cell balancing switch needs to be changed. In this case, for example, a duty ratio change signal indicating it may be output.

On the other hand, the change determination unit 430 may determine that the duty ratio of the cell balancing switch does not need to be changed when any one of the temperature satisfaction signal and the current satisfaction signal is not output from the temperature comparison unit 410 and the current comparison unit 420.

### 2.5. Count unit (500)

A count unit 500 is a component that counts the number of cell balancing cycles and the number of diagnosis counting.

### 2.5.1. Cycle number count unit (510)

A cycle number count unit 510 is a component that counts the number of cell balancing cycles when cell balancing is activated according to a result of the determination of the cell balancing necessity determination unit 300. More specifically, when a balancing start signal is output from the necessity determination unit 340 of the cell balancing necessity determination unit 300, the cycle number count unit 510 may be provided in the form of counting the number of cell balancing cycles from that point in time.

Meanwhile, as another embodiment of the cycle number count unit 510, a balancing time count unit that counts the cell balancing operating time may also be provided. In this case, for example, when a balancing start signal is output from the necessity determination unit 340 of the cell balancing necessity determination unit 300, the cycle number count unit 510 may be provided in the form of counting the cell balancing operating time from that point in time.

### 2.5.2. Number-of-diagnosis-counting count unit (520)

A number-of diagnosis-counting count unit 520 is a component that increases the number of diagnosis counting when a determination is made that an increase in the number of diagnosis counting is necessary as a result of determination of a diagnosis count increase determination unit 600, which will be described later.

More specifically, when the diagnosis counting increase signal is output from the diagnosis count increase determination unit 600, the number of diagnosis counting may be increased by +1.

### 2.6. Diagnosis count increase determination unit (600)

The diagnosis count increase determination unit 600 is a component that determines whether to increase the number of diagnosis counting depending on whether cell balancing needs to be continued and whether the number of cell balancing cycles (or cell balancing operating time) exceeds a predetermined reference number of cell balancing cycles (or cell balancing operating time).

The diagnosis count increase determination unit 600 may include the following sub-components.

### 2.6.1. Number comparison unit (610)

A number comparison unit 610 is a component that compares the number of cell balancing cycles counted by the cycle number count unit 510 of the count unit 500 with a predetermined reference number of cell balancing cycles, and outputs a signal corresponding to a result of the comparison.

More specifically, when the counted number of cell balancing cycles is less than or equal to the reference number of cell balancing cycles, the number comparison unit 610 may output, for example, a number-of-cycles-or-less signal indicating it.

On the other hand, when the counted number of cell balancing cycles exceeds the reference number of cell balancing cycles, the number comparison unit 610 may output, for example, a number-of-cycles-excess signal indicating it.

### 2.6.2. Increase determination unit (620)

An increase determination unit 620 is a component that determines the increase in the number of diagnosis counting, depending on the result of the comparison of the number comparison unit 610 and the result of the determination of whether cell balancing is to be continued by the cell balancing necessity determination unit 300.

More specifically, when the determination is made that cell balancing is to be continued and the number of cell balancing cycles (or cell balancing operating time) is less than or equal to the predetermined reference number of cell balancing cycles (or cell balancing operating time), the increase determination unit 620 determines that the number of diagnosis counting is not to be increased.

On the other hand, when the determination is made that cell balancing is to be continued and the number of cell balancing cycles (or cell balancing operating time) exceeds the predetermined reference number of cell balancing cycles (or cell balancing operating time), the increase determination unit 620 determines that the number of diagnosis counting is to be increased.

In other words, when the balancing continuation signal is output from the necessity determination unit 340 of the cell balancing necessity determination unit 300 and the cycle-number-or-less signal is output from the number comparison unit 610, the increase determination unit 620 may determine that the number of diagnosis counting is not to be increased and may, for example, output a diagnosis-counting-non-increase signal indicating it.

On the other hand, when the balancing continuation signal is output from the necessity determination unit 340 of the cell balancing necessity determination unit 300 and the cycle-number-excess signal is output from the number comparison unit 610, the increase determination unit 620 may determine that the number of diagnosis counting is to be increased and may, for example, output a diagnosis-counting-increase signal indicating it.

### 2.7. Cell balancing mode change determination unit (700)

A cell balancing mode change determination unit 700 is a component that determines whether to change the cell balancing mode depending on whether the number of diagnosis counting counted by the number-of-diagnosis-counting count unit 520 of the count unit 500 is less than or equal to a predetermined reference number of diagnosis counting.

More specifically, when the number of diagnosis counting counted by the number-of-diagnosis-counting count unit 520 is less than or equal to the reference number of diagnosis counting, the cell balancing mode change determination unit 700 may determine that the cell balancing mode needs to be changed, and may, for example, output a mode change signal indicating it.

On the other hand, when the number of diagnosis counting counted by the number-of-diagnosis-counting count unit 520 exceeds the reference number of diagnosis counting, the cell balancing mode change determination unit 700 may determine that the cell balancing mode does not need to be changed, and may, for example, output a mode non-change signal indicating it.

### 2.8. Cell balancing control unit (800)

A cell balancing control unit 800 is a component that controls the cell balancing operation of the cell balancing unit 900 according to the result of the determination of the cell balancing necessity determination unit 300.

More specifically, the cell balancing control unit is configured to control the cell balancing operation by activating a cell balancing operation with an initial duty ratio of the cell balancing switch and in an initial cell balancing mode when the cell balancing necessity determination unit 300 determines that the cell balancing is necessary, and then making setting by changing each of the duty ratio and the cell balancing mode depending on whether a condition is satisfied with a change in a battery state.

### 2.8.1. Switch control unit (810)

A switch control unit 810 turns on a cell balancing switch (not shown) of the cell balancing unit 900 with the initial duty ratio when the balancing start signal is output from the necessity determination unit 340 of the cell balancing necessity determination unit 300.

Here, the duty ratio of the cell balancing switch may be set to 20%, for example.

Then, the switch control unit 810 may turn on the cell balancing switch with the duty ratio of the cell balancing switch (not shown) set to be increased by a predetermined range when the duty ratio change signal is output from the change determination unit 430 of the duty ratio change determination unit 400.

Meanwhile, then, the switch control unit 810 may end the cell balancing operation by controlling the cell balancing switch (not shown) to be turned off, when the balancing end signal is output from the necessity determination unit 340 of the cell balancing necessity determination unit 300.

### 2.8.2. Cell balancing mode setting unit (820)

A cell balancing mode setting unit 820 sets the cell balancing mode to the initial cell balancing mode when the balancing start signal is output from the necessity determination unit 340 of the cell balancing necessity determination unit 300. Then, the cell balancing mode setting unit 820 may change and set the cell balancing mode in a predetermined order when the mode change signal is output from the cell balancing mode change determination unit 700.

Here, the cell balancing mode may be one of a charging mode, a standby mode, and a discharging mode.

In addition, a predetermined cell balancing mode change order may be set in the order of the charging mode, the standby mode, and the discharging mode.

For example, when the initial cell balancing mode is the charging mode, the cell balancing mode, which is changed to make setting, as the mode change signal is output from the cell balancing mode change determination unit 700, is switched to the standby mode.

### 2.9. Cell balancing unit (900)

The cell balancing unit 900 is a component that includes a cell balancing resistor (not shown) connected to a positive electrode of each battery bank 100 to consume voltage of the battery bank and a cell balancing switch (not shown) for turning on and off a connection path between the cell balancing resistor (not shown) and the battery bank 100 to control the voltage difference between the battery banks 100 by performing the cell balancing operation under the control of the cell balancing control unit 800.

Symbols and names of the reference signs used in and drawings of the present invention are as follows.
100: Battery bank
200: Battery information measurement unit
300: Cell balancing necessity determination unit
310: Voltage difference calculation unit
320: Voltage comparison unit
330: SOC comparison unit
340: Necessity determination unit
400: Duty ratio change determination unit
410: Temperature comparison unit
420: Current comparison unit
430: Change determination unit
500: Count unit
510: Cycle number count unit
520: Number-of-diagnosis-counting count unit
600: Diagnosis count increase determination unit
610: Number comparison unit
620: Increase determination unit
700: Cell balancing mode change determination unit
800: Cell balancing control unit
810: Switch control unit
820: Cell balancing mode setting unit
900: Cell balancing unit

## Claims

1. A battery pack comprising:
at least two or more battery banks (100) including a plurality of battery cells;
a battery information measurement unit (200) that measures battery information including current, voltage, temperature, and a state of charge of a battery at regular intervals;
a cell balancing necessity determination unit (300) that determines whether cell balancing is necessary by using the battery information acquired from the battery information measurement unit (200);
a duty ratio change determination unit (400) that determines whether a duty ratio of a cell balancing switch needs to be changed by using the battery information acquired from the battery information measurement unit (200), after a cell balancing operation is activated by a result of the determination of the cell balancing necessity determination unit (300);
a count unit (500) that counts a number of cell balancing cycles and a number of diagnosis counting; **characterized by**
a diagnosis count increase determination unit (600) that determines whether to increase the number of diagnosis counting depending on whether the cell balancing needs to be continued and whether the number of cell balancing cycles exceeds a predetermined reference number of cell balancing cycles; and
a cell balancing mode change determination unit (700) that determines whether to change the cell balancing mode depending on whether the number of diagnosis counting counted by the count unit (500) is less than or equal to a predetermined reference number of diagnosis counting, wherein the cell balancing mode is one of a charging mode, a standby mode, and a discharging mode.

2. The battery pack of claim 1, further comprising:
a cell balancing control unit (800) that activates a cell balancing operation with an initial cell balancing switch and in an initial cell balancing mode when the cell balancing necessity determination unit (300) determines that the cell balancing is necessary, and then makes setting by changing each of the duty ratio of the cell balancing switch and the cell balancing mode, depending on whether a predetermined condition is satisfied with a change in a battery state; and
a cell balancing unit (900) that includes a cell balancing resistor connected to a positive electrode of each battery bank (100) to consume voltage of the battery bank (100) and a cell balancing switch for turning on and off a connection path between the cell balancing resistor and the battery bank (100).

3. The battery pack of claim 2, wherein the cell balancing necessity determination unit (300) comprises:
a voltage difference calculation unit (310) that calculates a bank voltage difference that is a difference between a maximum voltage and a minimum voltage among voltage values of battery banks (100) included in the battery information acquired from the battery information measurement unit (200);
a voltage comparison unit (320) that compares a bank voltage difference value calculated by the voltage difference calculation unit (310) with a predetermined reference voltage difference value to determine whether the bank voltage difference value exceeds the predetermined reference voltage difference value, and outputs a signal corresponding to a result of the comparison;
an SOC comparison unit (330) that compares an SOC included in the battery information acquired from the battery information measurement unit (200) with values of a predetermined reference SOC range to determine whether the SOC is within the predetermined reference SOC range, and outputs an SOC satisfaction signal when the SOC is within the predetermined reference SOC range; and
a necessity determination unit (340) that determines that the cell balancing is necessary when the calculated bank voltage difference value exceeds the predetermined reference voltage difference value and the SOC is within the predetermined reference SOC range.

4. The battery pack of claim 3, wherein the voltage comparison unit (320) outputs a voltage-excess signal when the calculated bank voltage difference value exceeds the predetermined reference voltage difference value as the result of the comparison, and outputs a voltage-or-less signal when the calculated bank voltage difference value is less than or equal to the predetermined reference voltage difference value, and
the necessity determination unit (340) determines that the cell balancing is necessary and outputs a balancing start signal, when both the voltage-excess signal and the SOC satisfaction signal are output.

5. The battery pack of claim 4, wherein the necessity determination unit (340)
determines that the cell balancing is not to be continued and outputs a balancing end signal, when the voltage-or-less signal is output from the voltage comparison unit (320) after the balancing start signal is output, and
determines that the cell balancing is to be continued and outputs a balancing continuation signal, when the voltage-excess signal is output from the voltage comparison unit (320) after the balancing start signal is output.

6. The battery pack of claim 5, wherein the duty ratio change determination unit (400) comprises:
a temperature comparison unit (410) that, after the balancing start signal is output from the necessity determination unit (340), compares a BMS temperature included the battery information acquired from the battery information measurement unit (200) with a predetermined reference temperature to determine whether the BMS temperature is less than the predetermined reference temperature, and outputs a temperature satisfaction signal when the BMS temperature is less than the predetermined reference temperature;
a current comparison unit (420) that, after the balancing start signal is output from the necessity determination unit (340), compares a cell balancing current included the battery information acquired from the battery information measurement unit (200) with a predetermined reference current to determine whether the cell balancing current is less than the predetermined reference current, and outputs a current satisfaction signal when the cell balancing current is less than the predetermined reference current; and
a change determination unit (430) that determines whether the duty ratio of the cell balancing switch of the cell balancing unit (900) needs to be changed according to a result of comparisons of the temperature comparison unit (410) and the current comparison unit (420).

7. The battery pack of claim 6, wherein the change determination unit (430)
determines that the duty ratio of the cell balancing switch needs to be changed and outputs a duty ratio change signal, when both the temperature satisfaction signal and the current satisfaction signal are output from the temperature comparison unit (410) and the current comparison unit (420); and
determines that the duty ratio of the cell balancing switch does not need to be changed when any one of the temperature satisfaction signal and the current satisfaction signal is not output from the temperature comparison unit (410) and the current comparison unit (420).

8. The battery pack of claim 5, wherein the count unit (500) comprises a cycle number count unit (510) that, when the balancing start signal is output from the necessity determination unit (340) of the cell balancing necessity determination unit (300), counts the number of cell balancing cycles from a point in time when the balancing start signal is output.

9. The battery pack of claim 8, wherein the diagnosis count increase determination unit (600) comprises:
a number comparison unit (610) that compares the number of cell balancing cycles counted by the cycle number count unit (510) of the count unit (500) with the predetermined reference number of cell balancing cycles to determine whether the number of cell balancing cycles exceeds the predetermined reference number of cell balancing cycles, and outputs a cycle-number-excess signal when the number of cell balancing cycles exceeds the predetermined reference number of cell balancing cycles; and
an increase determination unit (620) that determines that the number of diagnosis counting is to be increased and outputs a diagnosis-counting-increase signal, when the balancing continuation signal is output from the necessity determination unit (340) of the cell balancing necessity determination unit (300) and the cycle-number-excess signal is output from the number comparison unit (610).

10. The battery pack of claim 9, wherein the count unit (500) further comprises a number-of-diagnosis-counting count unit (520) that increases the number of diagnosis counting when a diagnosis-counting-increase signal is output from the increase determination unit (620) of the diagnosis count increase determination unit (600).

11. The battery pack of claim 10, wherein the cell balancing mode change determination unit (700) determines that the cell balancing mode needs to be changed and outputs a mode change signal, when the number of diagnosis counting counted by the number-of-diagnosis-counting count unit (520) is less than or equal to the reference number of diagnosis counting.

12. The battery pack of claim 11, wherein the cell balancing control unit (800) comprises:
a switch control unit (810) that turns on the cell balancing switch of the cell balancing unit (900) with the initial duty ratio when the balancing start signal is output from the necessity determination unit (340) of the cell balancing necessity determination unit (300); and
a cell balancing mode setting unit (820) that sets the cell balancing mode to the initial cell balancing mode when the balancing start signal is output from the necessity determination unit (340) of the cell balancing necessity determination unit (300).

13. The battery pack of claim 12, wherein the switch control unit (810) of the cell balancing control unit (800)
turns on the cell balancing switch with the duty ratio of the cell balancing switch set to be increased by a predetermined range when the duty ratio change signal is output from the change determination unit (430) of the duty ratio change determination unit (400), and
turns off the cell balancing switch when the balancing end signal is output from the necessity determination unit (340) of the cell balancing necessity determination unit (300).

14. The battery pack of claim 12, wherein the cell balancing mode setting unit (820) of the cell balancing control unit (800) makes setting by changing the cell balancing mode when the mode change signal is output from the cell balancing mode change determination unit (700).

15. The battery pack of claim 14, wherein the cell balancing mode is one of a charging mode, a standby mode, and a discharging mode, and
changing of the cell balancing mode is set in an order of the charging mode, the standby mode, and the discharging mode.

## Patentansprüche

1. Batteriepack, umfassend:
wenigstens zwei oder mehr Batteriebänke (100), die eine Vielzahl von Batteriezellen enthalten;
eine Batterieinformation-Messeinheit (200), die Batterieinformationen einschließlich Strom, Spannung, Temperatur und Ladezustand einer Batterie in regelmäßigen Intervallen misst;
eine Zellen-Ausgleichserfordernis-Bestimmungseinheit (300), die unter Verwendung der von der Batterieinformation-Messeinheit (200) erfassten Batterieinformationen bestimmt, ob ein Zellenausgleich notwendig ist;
eine Tastverhältnisänderungs-Bestimmungseinheit (400), die unter Verwendung der von der Batterieinformation-Messeinheit (200) erfassten Batterieinformationen bestimmt, ob ein Tastverhältnis eines Zellenausgleichsschalters geändert werden muss, nachdem ein Zellenausgleichsvorgang durch ein Ergebnis der Bestimmung der Zellen-Ausgleichserfordernis-Bestimmungseinheit (300) aktiviert wurde;
eine Zähleinheit (500), die eine Anzahl von Zellenausgleichszyklen und eine Anzahl von Diagnosezählungen zählt; **gekennzeichnet durch**
eine Diagnosezählererhöhungs-Bestimmungseinheit (600), die in Abhängigkeit davon, ob der Zellenausgleich fortgesetzt werden muss und ob die Anzahl von Zellenausgleichszyklen eine vorbestimmte Referenzanzahl von Zellenausgleichszyklen überschreitet, bestimmt, ob die Anzahl von Diagnosezählungen erhöht werden muss; und
eine Zellenausgleichsmodus-Änderungs-Bestimmungseinheit (700), die in Abhängigkeit davon, ob die Anzahl von durch die Zähleinheit (500) gezählten Diagnosezählungen kleiner oder gleich einer vorbestimmten Referenzanzahl von Diagnosezählungen ist, bestimmt, ob der Zellenausgleichsmodus geändert werden muss, wobei der Zellenausgleichsmodus einer von einem Lademodus, einem Standby-Modus und einem Entlademodus ist.

2. Batteriepack nach Anspruch 1, ferner umfassend:
eine Zellenausgleich-Steuereinheit (800), die einen Zellenausgleichsvorgang mit einem anfänglichen Zellenausgleichsschalter und in einem anfänglichen Zellenausgleichsmodus aktiviert, wenn die Zellen-Ausgleichserfordernis-Bestimmungseinheit (300) bestimmt, dass der Zellenausgleich notwendig ist, und dann in Abhängigkeit davon, ob eine vorbestimmte Bedingung mit einer Änderung eines Batteriezustands erfüllt ist, eine Einstellung durch Ändern jeweils des Tastverhältnisses des Zellenausgleichsschalters und des Zellenausgleichsmodus vornimmt; und
eine Zellenausgleichseinheit (900), die einen Zellenausgleichswiderstand, der mit einer positiven Elektrode jeder Batteriebank (100) verbunden wird, um Spannung der Batteriebank (100) zu verbrauchen, und einen Zellenausgleichsschalter zum Ein- und Ausschalten eines Verbindungspfads zwischen dem Zellenausgleichswiderstand und der Batteriebank (100) enthält.

3. Batteriepack nach Anspruch 2, wobei die Zellen-Ausgleichserfordernis-Bestimmungseinheit (300) umfasst:
eine Spannungsdifferenz-Berechnungseinheit (310), die eine Bankspannungsdifferenz berechnet, die einer Differenz zwischen einer maximalen Spannung und einer minimalen Spannung von Spannungswerten der Batteriebänke (100) entspricht, die in den von der Batterieinformation-Messeinheit (200) erfassten Batterieinformationen enthalten sind;
eine Spannungsvergleichseinheit (320), die einen von der Spannungsdifferenz-Berechnungseinheit (310) berechneten Bankspannungsdifferenzwert mit einem vorbestimmten Referenzspannungsdifferenzwert vergleicht, um zu bestimmen, ob der Bankspannungsdifferenzwert den vorbestimmten Referenzspannungsdifferenzwert überschreitet, und ein Signal ausgibt, das einem Ergebnis des Vergleichs entspricht;
eine SOC-Vergleichseinheit (330), die einen in den von der Batterieinformation-Messeinheit (200) erfassten Batterieinformationen enthaltenen SOC mit Werten eines vorbestimmten Referenz-SOC-Bereichs vergleicht, um zu bestimmen, ob der SOC innerhalb des vorbestimmten Referenz-SOC-Bereichs liegt, und ein SOC-Erfüllungssignal ausgibt, wenn der SOC innerhalb des vorbestimmten Referenz-SOC-Bereichs liegt; und
eine Erfordernis-Bestimmungseinheit (340), die bestimmt, dass der Zellenausgleich notwendig ist, wenn der berechnete Bankspannungsdifferenzwert den vorbestimmten Referenzspannungsdifferenzwert überschreitet und der SOC innerhalb des vorbestimmten Referenz-SOC-Bereichs liegt.

4. Batteriepack nach Anspruch 3, wobei die Spannungsvergleichseinheit (320) ein Spannungsüberschusssignal ausgibt, wenn der berechnete Bankspannungsdifferenzwert den vorbestimmten Referenzspannungsdifferenzwert als Ergebnis des Vergleichs überschreitet, und
ein Spannung-oder-weniger-Signal ausgibt, wenn der berechnete Bankspannungsdifferenzwert kleiner oder gleich dem vorbestimmten Referenzspannungsdifferenzwert ist, und
die Erfordernis-Bestimmungseinheit (340) bestimmt, dass der Zellenausgleich notwendig ist, und ein Ausgleichsstartsignal ausgibt, wenn sowohl das Spannungsüberschusssignal als auch das SOC-Erfüllungssignal ausgegeben werden.

5. Batteriepack nach Anspruch 4, wobei die Erfordernis-Bestimmungseinheit (340)
bestimmt, dass der Zellenausgleich nicht fortgesetzt werden muss, und ein Ausgleichsendsignal ausgibt, wenn das Spannung-oder-weniger-Signal von der Spannungsvergleichseinheit (320) ausgegeben wird, nachdem das Ausgleichsstartsignal ausgegeben wurde, und
bestimmt, dass der Zellenausgleich fortgesetzt wird, und ein Ausgleichsfortsetzungssignal ausgibt, wenn das Spannungsüberschusssignal von der Spannungsvergleichseinheit (320) ausgegeben wird, nachdem das Ausgleichsstartsignal ausgegeben wurde.

6. Batteriepack nach Anspruch 5, wobei die Tastverhältnisänderungs-Bestimmungseinheit (400) umfasst:
eine Temperaturvergleichseinheit (410), die, nachdem das Ausgleichsstartsignal von der Erfordernis-Bestimmungseinheit (340) ausgegeben wurde, eine BMS-Temperatur, die in den von der Batterieinformation-Messeinheit (200) erfassten Batterieinformationen enthalten ist, mit einer vorbestimmten Referenztemperatur vergleicht, um zu bestimmen, ob die BMS-Temperatur niedriger als die vorbestimmte Referenztemperatur ist, und ein Temperaturerfüllungssignal ausgibt, wenn die BMS-Temperatur niedriger als die vorbestimmte Referenztemperatur ist;
eine Stromvergleichseinheit (420), die, nachdem das Ausgleichsstartsignal von der Erfordernis-Bestimmungseinheit (340) ausgegeben wurde, einen Zellenausgleichsstrom, der in den von der Batterieinformation-Messeinheit (200) erfassten Batterieinformationen enthalten ist, mit einem vorbestimmten Referenzstrom vergleicht, um zu bestimmen, ob der Zellenausgleichsstrom niedriger als der vorbestimmte Referenzstrom ist, und ein Stromerfüllungssignal ausgibt, wenn der Zellenausgleichsstrom niedriger als der vorbestimmte Referenzstrom ist; und
eine Änderungsbestimmungseinheit (430), die gemäß einem Ergebnis von Vergleichen der Temperaturvergleichseinheit (410) und der Stromvergleichseinheit (420) bestimmt, ob das Tastverhältnis des Zellenausgleichsschalters der Zellenausgleichseinheit (900) geändert werden muss.

7. Batteriepack nach Anspruch 6, wobei die Änderungsbestimmungseinheit (430)
bestimmt, dass das Tastverhältnis des Zellenausgleichsschalters geändert werden muss, und ein Tastverhältnisänderungssignal ausgibt, wenn sowohl das Temperaturerfüllungssignal als auch das Stromerfüllungssignal von der Temperaturvergleichseinheit (410) und der Stromvergleichseinheit (420) ausgegeben werden; und
bestimmt, dass das Tastverhältnis des Zellenausgleichsschalters nicht geändert werden muss, wenn eines von dem Temperaturerfüllungssignal und dem Stromerfüllungssignal nicht von der Temperaturvergleichseinheit (410) und der Stromvergleichseinheit (420) ausgegeben wird.

8. Batteriepack nach Anspruch 5, wobei die Zähleinheit (500) eine Zyklusanzahl-Zähleinheit (510) umfasst, die, wenn das Ausgleichsstartsignal von der Erfordernis-Bestimmungseinheit (340) der Zellen-Ausgleichserfordernis-Bestimmungseinheit (300) ausgegeben wird, die Anzahl von Zellenausgleichszyklen ab einem Zeitpunkt zählt, zu dem das Ausgleichsstartsignal ausgegeben wird.

9. Batteriepack nach Anspruch 8, wobei die Diagnosezählererhöhungs-Bestimmungseinheit (600) umfasst:
eine Anzahlvergleichseinheit (610), die die von der Zyklusanzahl-Zähleinheit (510) der Zähleinheit (500) gezählte Anzahl von Zellenausgleichszyklen mit der vorbestimmten Referenzanzahl von Zellenausgleichszyklen vergleicht, um zu bestimmen, ob die Anzahl von Zellenausgleichszyklen die vorbestimmte Referenzanzahl von Zellenausgleichszyklen überschreitet, und ein Zyklusanzahl-Überschusssignal ausgibt, wenn die Anzahl von Zellenausgleichszyklen die vorbestimmte Referenzanzahl von Zellenausgleichszyklen überschreitet; und
eine Erhöhungsbestimmungseinheit (620), die bestimmt, dass die Anzahl von Diagnosezählungen erhöht werden muss, und ein Diagnosezählung-Erhöhungssignal ausgibt, wenn das Ausgleichsfortsetzungssignal von der Erfordernis-Bestimmungseinheit (340) der Zellen-Ausgleichserfordernis-Bestimmungseinheit (300) ausgegeben wird und das Zyklusanzahl-Überschusssignal von der Anzahlvergleichseinheit (610) ausgegeben wird.

10. Batteriepack nach Anspruch 9, wobei die Zähleinheit (500) ferner eine Diagnosezählungsanzahl-Zähleinheit (520) umfasst, die die Anzahl von Diagnosezählungen erhöht, wenn ein Diagnosezählung-Erhöhungssignal von der Erhöhungsbestimmungseinheit (620) der Diagnosezählererhöhungs-Bestimmungseinheit (600) ausgegeben wird.

11. Batteriepack nach Anspruch 10, wobei die Zellenausgleichsmodus-Änderungs-Bestimmungseinheit (700) bestimmt, dass der Zellenausgleichsmodus geändert werden muss, und ein Modusänderungssignal ausgibt, wenn die Anzahl von durch die Diagnosezählungsanzahl-Zähleinheit (520) gezählten Diagnosezählungen kleiner oder gleich der Referenzanzahl von Diagnosezählungen ist.

12. Batteriepack nach Anspruch 11, wobei die Zellenausgleichssteuereinheit (800) umfasst:
eine Schaltersteuereinheit (810), die den Zellenausgleichsschalter der Zellenausgleichseinheit (900) mit dem anfänglichen Tastverhältnis einschaltet, wenn das Ausgleichsstartsignal von der Erfordernis-Bestimmungseinheit (340) der Zellenausgleichserfordernis-Bestimmungseinheit (300) ausgegeben wird; und
eine Zellenausgleichsmodus-Einstelleinheit (820), die den Zellenausgleichsmodus auf den anfänglichen Zellenausgleichsmodus einstellt, wenn das Ausgleichsstartsignal von der Erfordernis-Bestimmungseinheit (340) der Zellenausgleichserfordernis-Bestimmungseinheit (300) ausgegeben wird.

13. Batteriepack nach Anspruch 12, wobei die Schaltersteuereinheit (810) der Zellenausgleichssteuereinheit (800)
den Zellenausgleichsschalter einschaltet, wenn das Tastverhältnis des Zellenausgleichsschalters so eingestellt ist, dass es um einen vorbestimmten Bereich erhöht wird, wenn das Tastverhältnisänderungssignal von der Änderungsbestimmungseinheit (430) der Tastverhältnisänderungs-Bestimmungseinheit (400) ausgegeben wird, und
den Zellenausgleichsschalter ausschaltet, wenn das Ausgleichsendsignal von der Erfordernis-Bestimmungseinheit (340) der Zellenausgleichserfordernis-Bestimmungseinheit (300) ausgegeben wird.

14. Batteriepack nach Anspruch 12, wobei die Zellenausgleichsmodus-Einstelleinheit (820) der Zellenausgleichssteuereinheit (800) eine Einstellung durch Ändern des Zellenausgleichsmodus vornimmt, wenn das Modusänderungssignal von der Zellenausgleichsmodus-Änderungs-Bestimmungseinheit (700) ausgegeben wird.

15. Batteriepack nach Anspruch 14, wobei der Zellenausgleichsmodus einer von einem Lademodus, einem Standby-Modus und einem Entlademodus ist, und
das Ändern des Zellenausgleichsmodus in einer Reihenfolge des Lademodus, des Standby-Modus und des Entlademodus eingestellt wird.

## Revendications

1. Bloc-batterie comprenant :
au moins deux ou plusieurs banques de batteries (100) comprenant une pluralité de cellules de batteries;
un module de mesure des informations sur les batteries (200) mesurant des informations sur les batteries, y compris le courant, la tension, la température et un état de charge d'une batterie à des échéances régulières ;
un dispositif de détermination de la nécessité d'un équilibrage de cellule (300), qui détermine si un équilibrage des cellules est nécessaire en utilisant les informations sur la batterie acquises du module de mesure des informations sur les batteries (200) ;
une unité de détermination de changement du rapport cyclique (400), qui détermine si un rapport cyclique d'un commutateur d'équilibrage de cellules doit être changé, en utilisant les informations sur la batterie acquises du module de mesure des informations sur les batteries (200), suivant l'activation d'une opération d'équilibrage d'une cellule par un résultat de la détermination du dispositif de détermination de la nécessité d'un équilibrage de cellule (300) ;
une unité de comptage (500) comptant un certain nombre de cycles d'équilibrage de cellule et un nombre de comptages de diagnostic ; **caractérisée par**
un module de détermination d'une augmentation du comptage de diagnostic (600), déterminant la nécessité d'une augmentation du nombre de comptages de diagnostic, en fonction de la nécessité de poursuivre l'équilibrage des cellules et selon que le nombre de cycles d'équilibrage de cellules dépasse un nombre de référence prédéterminé de cycles d'équilibrage de cellule ; et
un module de détermination du changement de mode d'équilibrage de cellule (700), déterminant la nécessité de modifier le mode d'équilibrage de cellule selon que le nombre de comptages de diagnostic compté par l'unité de comptage (500) est inférieur ou égal à un nombre de référence prédéterminé de comptage de diagnostic, le mode d'équilibrage de cellule étant un mode de charge, un mode de veille, et un mode de décharge.

2. Bloc-batterie selon la revendication 1, comprenant en outre :
un module de commande d'équilibrage de cellule (800), qui déclenche une opération d'équilibrage de cellules avec un commutateur d'équilibrage initial des cellule, et, dans un mode d'équilibrage initial de cellule, lorsque le dispositif de détermination de la nécessité d'un équilibrage de cellule (300) établit qu'un équilibrage de la cellules est nécessaire, puis effectue un réglage en modifiant chacun du rapport cyclique du commutateur d'équilibrage de cellules et du mode d'équilibrage de cellule, selon qu'une condition prédéterminée est remplie par un changement de l'état d'une batterie ; et
un module d'équilibrage de cellule (900) comprenant une résistance d'équilibrage de cellule reliée à une électrode positive de chaque banque de batteries (100) pour consommer la tension de la banque de batteries (100), et un commutateur d'équilibrage de cellules pour activer ou désactiver un chemin de connexion entre la résistance d'équilibrage de cellule et la banque de batteries (100).

3. Bloc-batterie selon la revendication 2, le dispositif de détermination de la nécessité d'un équilibrage de cellule (300) comprenant :
une unité de calcul de différence de tension (310) qui calcule une différence de tension de banque, à savoir une différence entre une tension maximale et une tension minimale parmi les valeurs de tension des banques de batteries (100) comprises dans les informations de batterie acquises du module de mesure des informations sur les batteries (200) ;
une unité de comparaison de la tension (320), comparant une valeur de différence de tension de banque calculée par l'unité de calcul de différence de tension (310) avec une valeur de différence de tension de référence prédéterminée pour établir si la valeur de la différence de tension de banque est supérieure à la valeur de différence de tension de référence prédéterminée, et émettant un signal correspondant au résultat de la comparaison ;
une unité de comparaison de l'état de charge (330), comparant un état de charge inclus dans les informations sur la batterie acquises du module de mesure des informations sur les batteries (200) avec des valeurs d'une plage d'états de charge de référence prédéterminée afin d'établir si l'état de charge est compris dans la plage d'états de charge de référence prédéterminée, et émettant un signal de satisfaction avec l'état de charge lorsque l'état de charge est compris dans la plage d'états de charge de référence prédéterminée ; et
un dispositif de détermination de la nécessité (340), qui détermine si l'équilibrage de la cellule est nécessaire lorsque la valeur calculée de la différence de tension de banque est supérieure à la valeur de différence de tension de référence prédéterminée, et l'état de charge est compris dans la plage d'états de charge de référence prédéterminée.

4. Bloc-batterie selon la revendication 3, l'unité de comparaison de la tension (320) émettant un signal d'excès de tension lorsque la valeur calculée de différence de tension de banque est supérieure à la valeur de différence de tension de référence prédéterminée à la suite de la comparaison, et
émettant un signal de tension ou moins lorsque la valeur calculée de la différence de tension de banque est inférieure ou égale à la valeur de différence de tension de référence prédéterminée, et
le dispositif de détermination de la nécessité (340) établissant que l'équilibrage de la cellule est nécessaire et émettant un signal de lancement d'équilibrage lorsque le signal d'excès de tension et le signal de satisfaction avec l'état de charge sont émis tous les deux.

5. Bloc-batterie selon la revendication 4, le dispositif de détermination de la nécessité (340)
établissant que l'équilibrage de cellule ne doit pas être poursuivi et émettant un signal de fin d'équilibrage, lorsque le signal de tension ou moins est émis par l'unité de comparaison de tension (320) après l'émission du signal de lancement d'équilibrage, et
établissant si l'équilibrage de cellule doit être poursuivi, et émettant un signal de poursuite de l'équilibrage, lorsque le signal d'excès de tension est émis par l'unité de comparaison de tension (320) après l'émission du signal de lancement d'équilibrage.

6. Bloc-batterie selon la revendication 5, l'unité de détermination de changement du rapport cyclique (400) comprenant :
une unité de comparaison de la température (410) qui, après l'émission du signal de lancement d'équilibrage par le dispositif de détermination de la nécessité (340), compare une température du BMS (système de gestion de batterie) comprenant les informations sur la batterie acquises de l'unité de mesure d'informations sur la batterie (200) avec une température de référence prédéterminée afin de déterminer si la température du BMS est inférieure à la température de référence prédéterminée, et émettant un signal de satisfaction de température lorsque la température du BMS est inférieure à la température de référence prédéterminée ;
une unité de comparaison du courant (420) qui, après l'émission du signal de lancement d'équilibrage par le dispositif de détermination de la nécessité (340), compare un courant d'équilibrage de cellule comprenant les informations acquises de l'unité de mesure des informations sur la batterie (200), avec un courant de référence prédéterminé afin de déterminer si le courant d'équilibrage de cellule est inférieur au courant de référence prédéterminé, et émet un signal de satisfaction de courant lorsque le courant d'équilibrage de cellule est inférieur au courant de référence prédéterminé ; et
une unité de détermination d'un changement (430) qui détermine si le rapport cyclique du commutateur d'équilibrage de cellule de l'unité d'équilibrage de cellules (900) doit être modifié en fonction du résultat de comparaisons entre l'unité de comparaison de la température (410) et l'unité de comparaison du courant (420).

7. Bloc-batterie selon la revendication 6, l'unité de détermination d'un changement (430)
déterminant que le rapport cyclique du commutateur d'équilibrage de cellule doit être changé, et émettant un signal de changement du rapport cyclique, lorsqu'à la fois le signal de satisfaction de la température et le signal de satisfaction du courant sont émis par l'unité de comparaison de la température (410) et l'unité de comparaison du courant (420) ; et
déterminant qu'il n'est pas nécessaire de changer le rapport cyclique du commutateur d'équilibrage de cellule lorsqu'un quelconque du signal de satisfaction de la température et le signal de satisfaction du courant n'est pas émis par l'unité de comparaison de la température (410) et l'unité de comparaison du courant (420).

8. Bloc-batterie selon la revendication 5, l'unité de comptage (500) comprenant une unité de comptage de nombre de cycles (510) qui, lors de l'émission du signal de lancement d'équilibrage par le dispositif de détermination de la nécessité (340) du dispositif de détermination de la nécessité d'un équilibrage de cellule (300), compte le nombre de cycles d'équilibrage des cellule à partir d'un moment où le signal de lancement de l'équilibrage est émis.

9. Bloc-batterie selon la revendication 8, le module de détermination d'une augmentation du comptage de diagnostic (600) comprenant :
une unité de comparaison de nombres (610) qui compare le nombre de cycles d'équilibrage de cellule comptés par l'unité de comptage de nombre de cycles (510) de l'unité de comptage (500) avec le nombre de référence prédéterminé de cycles d'équilibrage de cellule pour déterminer si le nombre de cycles d'équilibrage de cellules dépasse le nombre de référence prédéterminé de cycles d'équilibrage de cellule, et émet un signal d'excès de nombre de cycles lorsque le nombre de cycles d'équilibrage de cellule dépasse le nombre de référence prédéterminé de cycles d'équilibrage de cellule ; et
une unité de détermination d'augmentation (620) déterminant que le nombre de comptage de diagnostic doit être augmenté, et émettant un signal d'augmentation du nombre de diagnostic, le signal de poursuite de l'équilibrage étant émis par le dispositif de détermination de la nécessité (340) du dispositif de détermination de la nécessité d'un équilibrage de cellule (300) et le signal d'excès du nombre de cycles étant émis par l'unité de comparaison de nombres (610).

10. Bloc-batterie selon la revendication 9, l'unité de comptage (500) comprenant en outre une unité de comptage du nombre de comptage de diagnostic (520), qui augmente le nombre de comptages de diagnostic lorsqu'un signal d'augmentation de comptage de diagnostic est émis par l'unité de détermination d'augmentation (620) du module de détermination d'une augmentation du comptage de diagnostic (600).

11. Bloc-batterie de la revendication 10, le module de détermination du changement de mode d'équilibrage de cellule (700) décidant que le mode d'équilibrage de cellule doit être modifié, et émettant un signal de changement de mode, lorsque le nombre de comptage de diagnostic compté par l'unité de comptage du nombre de comptage de diagnostic (520) est inférieur ou égal au nombre de référence du comptage de diagnostic.

12. Bloc-batterie selon la revendication 11, le module de commande d'équilibrage de cellule (800) comprenant :
une commande de commutation (810) qui allume le commutateur d'équilibrage de cellule de l'unité d'équilibrage de cellules (900) avec le rapport cyclique initial lorsque le signal de lancement de l'équilibrage est émis par le dispositif de détermination de la nécessité (340) du dispositif de détermination de la nécessité d'un équilibrage de cellule (300) ; et
un dispositif de réglage du mode d'équilibrage de cellule (820) qui établit le mode d'équilibrage de cellules d'après le mode d'équilibrage de cellule initial lorsque le signal de lancement de l'équilibrage est émis par le dispositif de détermination de la nécessité (340) du dispositif de détermination de la nécessité d'un équilibrage de cellule (300).

13. Bloc-batterie selon la revendication 12, la commande de commutation (810) du module de commande d'équilibrage de cellule (800)
activant le commutateur d'équilibrage de cellule, le rapport cyclique du commutateur d'équilibrage de cellule étant réglé de façon à être incrémenté d'une plage prédéterminée lors de l'émission du signal de changement du rapport cyclique par l'unité de détermination d'un changement (430) de l'unité de détermination de changement du rapport cyclique (400), et
désactivant le commutateur d'équilibrage de cellule lorsque le signal de fin d'équilibrage est émis par le dispositif de détermination de la nécessité (340) du dispositif de détermination de la nécessité d'équilibrage de cellule (300).

14. Bloc-batterie selon la revendication 12, le dispositif de réglage du mode d'équilibrage de cellule (820) du module de commande d'équilibrage de cellule (800) effectue le réglage en changeant le mode de l'unité d'équilibrage de cellule lorsque le signal de changement de mode est émis par le module de détermination du changement de mode d'équilibrage de cellule (700).

15. Bloc-batterie de la revendication 14, le mode d'équilibrage de cellule étant un des suivants: mode de charge, mode de veille, et mode de décharge, et
le changement du mode d'équilibrage de cellule étant réglé selon un ordre du mode de charge, du mode de veille et du mode de décharge.
